# FASCICULE DE BREVET EUROPEEN

(11) **EP 1 421 622 B1**
(45) Date de publication et mention de la délivrance du brevet: **31.10.2007**
(21) Numéro de dépôt: 02796331.3
(22) Date de dépôt: 30.08.2002
(51) Int. Cl.: H01L 27/146, H01L 31/0216

(54) **CAPTEUR D'IMAGE COULEUR SUR SUBSTRAT TRANSPARENT ET PROCEDE DE FABRICATION**
FARBBILDSENSOR AUF EINEM TRANSPARENTEN SUBSTRAT UND VERFAHREN ZU SEINER HERSTELLUNG
COLOUR IMAGE SENSOR ON TRANSPARENT SUBSTRATE AND METHOD FOR MAKING SAME

(30) Priorité: 31.08.2001 FR 0111335
(43) Date de publication de la demande: 26.05.2004
(73) Titulaire: E2V SEMICONDUCTORS, 38120 Saint Egreve (FR)
(72) Inventeur: BRISSOT, Louis, Thales Intellectual Property, F-94117 Arcueil Cedex (FR); POURQUIER, Eric Thales Intellectual Property, F-94117 Arcueil Cedex (FR)
(74) Mandataire: Guérin, Michel
(86) Numéro de dépôt international: PCT/FR2002/002977
(87) Numéro de publication internationale: WO 2003/019667

(56) Documents cités:
- US-A- 4 758 734
- US-A- 5 244 817
- US-A- 5 274 250
- US-B1- 6 204 087
- US-B1- 6 257 491

## Description

L'invention concerne les capteurs d'image électroniques, et notamment les capteurs de très petites dimensions permettant de réaliser des caméras miniatures, telles que celles qu'on peut vouloir incorporer à un téléphone portable.

Le document US 5,244,817 décrit un capteur d'image avec un substrat permanent et un procéde de fabrication utilisant un substrat provisoire.

Outre un encombrement très réduit, on souhaite que le capteur d'image ait une bonne sensibilité en faible lumière et de bonnes performances colorimétriques.

D'autre part, il est nécessaire de réaliser l'ensemble de la caméra par des procédés les plus économiques possibles pour ne pas aboutir à un coût rédhibitoire de l'appareil.

Pour y parvenir, on essaye d'une part de réaliser le capteur d'image et les circuits électroniques associés si possible sur un même substrat de silicium, et, d'autre part, on essaye de réaliser autant que possible les dépôts de couches diverses, les gravures, les traitements thermiques, etc. d'une manière collective sur une tranche de silicium (ou "wafer") comportant de nombreux capteurs identiques, avant de découper la tranche en capteurs individuels.

Cependant, les procédés de fabrication et les structures de capteur d'image qui ont été proposées jusqu'à maintenant ne donnent pas entièrement satisfaction de ce point de vue : les procédés de fabrication ne sont pas industriellement efficaces ; ils restent trop coûteux et de rendement trop faible pour des applications de grande série, ou bien les performances du capteur d'image ne sont pas suffisamment bonnes.

La présente invention vise à proposer un procédé de fabrication et un capteur d'image correspondant qui minimise les coûts de fabrication tout en présentant de bonnes qualités et notamment un faible encombrement, une bonne sensibilité et de bonnes performances colorimétriques.

A cet effet, l'invention propose un procédé de fabrication d'un capteur d'image, comprenant :
- la formation, sur la face avant d'une tranche semiconductrice, d'une série de zones actives comportant des circuits de détection d'image et correspondant chacune à un capteur d'image respectif, chaque zone active étant entourée de plots d'entrée/sortie,
- le report de la tranche par sa face avant contre la face avant d'un substrat de support provisoire,
- l'élimination de la majeure partie de l'épaisseur de la tranche semiconductrice, laissant subsister sur le substrat une fine couche semiconductrice comprenant les circuits de détection d'image,
ce procédé étant caractérisé en ce que :
- d'une part on dépose et on grave ultérieurement des couches de filtres de couleur sur la tranche semiconductrice ainsi amincie,
- d'autre part, postérieurement à la gravure des filtres de couleur, on reporte l'ensemble du substrat provisoire et de la tranche sur un substrat définitif, transparent, appliqué du côté du substrat provisoire qui porte les filtres de couleur,
- puis, on enlève au moins la majeure partie du substrat provisoire, pour permettre un accès facile aux plots d'entrée/sortie,
- et enfin, on découpe le substrat en capteurs individuels.

Le matériau semiconducteur de la couche amincie est de préférence un matériau monocristallin, et notamment du silicium pour les applications les plus courantes en lumière visible.

Le substrat provisoire peut être totalement enlevé, mettant à nu les plots d'entrée/sortie auxquels ont peut ensuite relier des connexions vers l'extérieur du capteur. Mais on peut aussi ne l'enlever que partiellement, en laissant une couche fine qui protège la tranche semiconductrice ; dans ce cas il faut former des ouvertures dans cette fine couche pour accéder aux plots d'entrée/sortie.

De préférence, les zones actives comprennent à la fois une matrice d'éléments photosensibles, des circuits de commande de la matrice, et des circuits de traitement d'image associés recevant des signaux issus des éléments photosensibles de la zone active. Les circuits ainsi associés à la matrice sont de préférence masqués contre la lumière par une couche d'aluminium, seule la matrice étant exposée à la lumière. Cette couche d'aluminium est formée sur le substrat transparent.

Le report de la tranche semiconductrice sur le substrat provisoire peut se faire par collage, par soudure classique, par soudure anodique (connue sous l'appellation anglo-saxonne "anodic bonding"), ou par simple adhérence moléculaire (force de contact très élevée entre deux surfaces de grande planéité). Le report du substrat provisoire sur le substrat définitif se fera de préférence par collage ou par adhérence moléculaire.

L'amincissement de la tranche après report sur le substrat et avant dépôt des filtres colorés peut se faire de plusieurs manières différentes : amincissement par rodage, amincissement chimique, combinaison des deux types (d'abord mécanique puis finition chimique, ou bien usinage mécanique en présence de produits chimiques) ; on peut aussi procéder à l'amincissement par fragilisation préalable de la tranche au niveau du plan de coupe désiré, notamment par implantation d'hydrogène en profondeur dans le plan de découpe désiré. Dans ce dernier cas, l'implantation d'hydrogène est faite à faible profondeur dans la tranche semiconductrice, avant le report de la tranche sur le substrat. L'amincissement est fait ensuite par un traitement thermique qui dissocie la tranche au niveau du plan de découpe implanté, laissant une fine couche semiconductrice en contact avec le substrat.

L'amincissement très important de la tranche fait passer l'épaisseur de celle-ci de plusieurs centaines de microns avant report sur le substrat à 3 à 20 micromètres après report sur le substrat. L'amincissement est un facteur de qualité important des capteurs puisqu'il augmente les performances colorimétriques et la sensibilité. Avec des capteurs non amincis, éclairés par le côté où sont formés de multiples couches isolantes et conductrices servant à la définition des circuits de détection d'image, la lumière ayant traversé un filtre coloré est dispersée sur des points photosensibles correspondant à des couleurs différentes, détériorant les performances colorimétriques. De plus, la sensibilité d'un capteur aminci est améliorée parce que les photons arrivent sur une plus large zone de silicium que dans les capteurs non amincis, n'étant pas arrêtés par les couches métalliques qui sont opaques et qui occupent une grande partie de la surface correspondant à chaque point photosensible.

On comprend que l'amincissement complique cependant les problèmes de fabrication du fait qu'après amincissement le silicium perd sa rigidité et devient très fragile, et que se pose de plus un problème de connexion des circuits de détection d'image avec l'extérieur. La solution selon l'invention permet de pallier cette difficulté et permet de fabriquer des capteurs d'image avec un bon rendement.

Dans le capteur définitif, la lumière est reçue à travers le substrat définitif transparent, les plots de connexion étant situés de l'autre côté, ce qui permet de monter le capteur en technique flip-chip (puce retournée plots de connexion contre la carte de circuit imprimé). Les pertes de lumière à travers le substrat transparent (réalisé en verre ou en matière plastique) sont faibles.

Le substrat définitif et la couche de silicium sont en contact étroit et les éléments de circuit actifs de la tranche sont donc bien protégés.

A titre d'exemple, l'épaisseur du substrat définitif est d'environ 500 micromètres, pour un substrat de 15 à 20 centimètres de diamètre ; l'épaisseur de la tranche de silicium est de 500 à 1000 micromètres avant amincissement (diamètre de 15 à 30 centimètres), puis de 3 à 20 micromètres après amincissement.

Des couches de planarisation, par exemple en polyimide, peuvent être déposées sur la tranche de silicium avant report sur le substrat intermédiaire et avant report du substrat intermédiaire sur le substrat définitif.

Il est à noter que le substrat intermédiaire est dans certains cas réutilisable d'une fabrication à la suivante.

L'objet de l'invention est donc un capteur d'image comportant un substrat transparent à la partie supérieure duquel sont superposés dans l'ordre une mosaïque de filtres colorés, une couche semiconductrice monocristalline très mince (épaisseur de quelques dizaines de micromètres au plus) (30) dans laquelle est formé un réseau matriciel de zones photosensibles, et un empilement de couches isolantes et conductrices définissant des circuits de détection d'image permettant de recueillir des charges électriques générées par l'illumination des zones photosensibles à travers le substrat transparent, de manière que la lumière passe dans l'ordre à travers le substrat transparent, puis les filtres de couleur, puis les zones semiconductrices photosensibles, avant d'atteindre l'empilement de couches isolantes et conductrices, sans rencontrer un réseau de couches conductrices avant d'atteindre le réseau de zones photosensibles.

Le substrat transparent est de préférence en verre ou en matière plastique mais peut être aussi en céramique ou en matériau cristallin.

D'autres caractéristiques et avantages de l'invention apparaîtront à la lecture de la description détaillée qui suit et qui est faite en référence aux dessins annexés dans lesquels :
- la figure 1 représente la structure d'un capteur d'image réalisé sur une tranche de silicium avant mise en place de filtres colorés ;
- la figure 2 représente l'opération de report de la tranche de silicium par sa face avant sur un substrat provisoire ;
- la figure 3 représente le substrat provisoire avec la tranche de silicium après amincissement de la tranche ;
- la figure 4 représente le substrat provisoire, portant une couche de silicium amincie sur laquelle on a déposé une mosaïque de filtres colorés;
- la figure 5 représente le substrat définitif sur lequel on a reporté, par sa face portant les filtres colorés, le substrat provisoire ;
- la figure 6 représente le substrat définitif après élimination de la totalité de l'épaisseur du substrat provisoire ;
- la figure 7 représente une variante de réalisation dans laquelle on a éliminé la majeure partie mais non la totalité du substrat provisoire, et on a formé des ouvertures d'accès à des contacts.

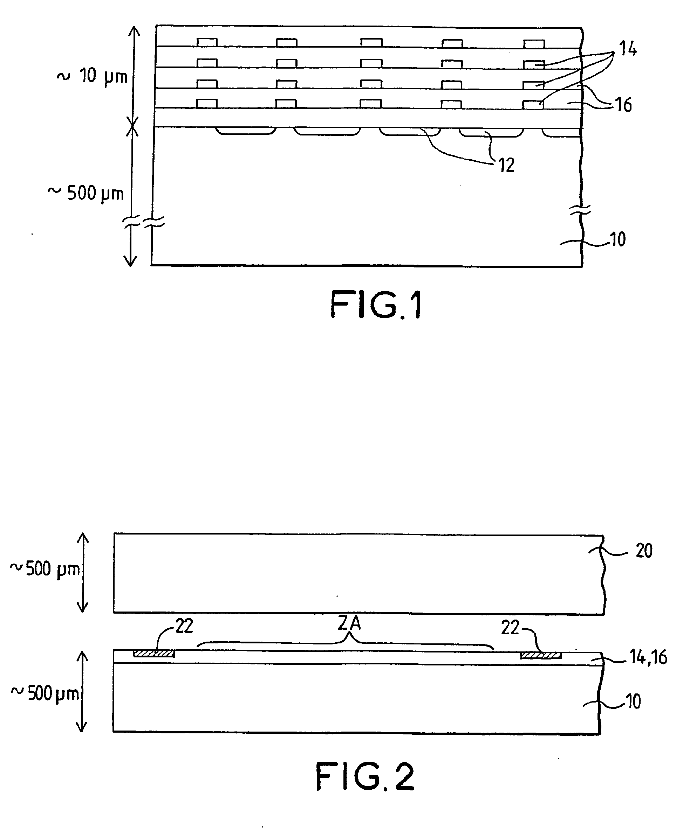

La figure 1 représente la structure générale d'une tranche de silicium sur laquelle on a réalisé par des techniques classiques les circuits de détection d'image d'une multiplicité de capteurs d'image.

La tranche de silicium 10 (ou "wafer") a une épaisseur de plusieurs centaines de micromètres, pour un diamètre de 150 à 300 millimètres.

Les circuits de détection d'image (matrice de points photosensibles, transistors, interconnexions) sont fabriqués sur une face de la tranche de silicium, qu'on peut appeler face avant et qui est la face supérieure sur la figure 1. La fabrication implique d'une part des diffusions et implantations diverses dans le silicium, à partir de la face supérieure de la tranche, pour former notamment des zones photosensibles 12, et d'autre part des dépôts et gravures successives de couches conductrices 14 et de couches isolantes 16 formant un empilement au-dessus des zones photosensibles 12. Les couches isolantes et conductrices font partie des circuits de détection d'image et permettent le recueil des charges électriques engendrées dans les zones photosensibles par une image projetée sur le capteur.

Une des couches conductrices 14, en principe la couche déposée en dernier, sert à former des plots d'entrée/sortie de chaque capteur individuel (plots non visibles sur la figure 1) autour d'une zone active comprenant la matrice de points photosensibles.

Si le capteur était réalisé avec une technologie classique, on déposerait alors à la surface de la tranche une mosaïque de filtres colorés.

Selon l'invention, on ne dépose pas de filtres colorés à ce stade mais on reporte la tranche par sa face avant sur un substrat provisoire 20 (figure 2). Le substrat provisoire est une tranche de même diamètre que la tranche 10 et d'épaisseur analogue pour assurer la rigidité de la structure pendant la fabrication ; il peut d'ailleurs être constitué par une autre tranche de silicium ; le report peut être effectué après dépôt d'une couche de "planarisation" servant à combler les reliefs créés sur la face avant de la tranche de silicium par les opérations de dépôt et gravure de l'empilement de couches conductrices et isolantes. Cette couche de planarisation n'a pas besoin d'être transparente.

Sur la figure 2, on a représenté la structure à une échelle plus petite qu'à la figure 1, pour montrer l'ensemble d'un capteur individuel comportant une zone active ZA et des plots de connexion 22 autour de la zone active ZA. Les plots 22, en contact avec une couche conductrice 14 ou faisant partie d'une couche 14, affleurent de préférence à l'interface entre les deux tranches 10 et 20 ; si une couche de planarisation a été déposée, on s'arrange de préférence pour qu'elle ne recouvre pas les plots 22. Toutefois, si les plots étaient recouverts par la couche de planarisation, on verra ultérieurement que des ouvertures peuvent de toutes façons être faites pour accéder à ces plots à la fin du processus de fabrication.

Le report de la tranche de silicium sur la tranche de support 20 peut se faire par plusieurs moyens, le moyen le plus simple pouvant être tout simplement un maintien par adhérence moléculaire, la grande planéité des surfaces en contact engendrant des forces de contact très élevées. Un collage est possible également .

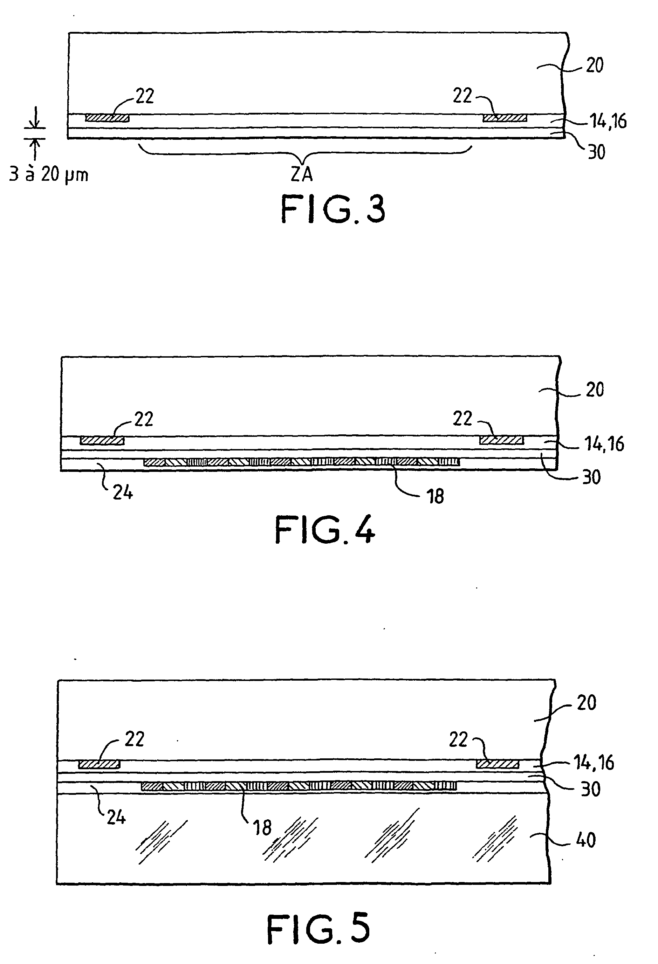

Après report de la tranche de silicium par sa face avant sur la tranche de support, on élimine la majeure partie de l'épaisseur de la tranche de silicium 10 pour n'en laisser subsister qu'une épaisseur d'environ 8 à 30 micromètres, incluant l'épaisseur de l'empilement de couches 14, 16. Ce qui subsiste de la tranche de silicium n'est plus qu'une superposition de quelques micromètres (par exemple de 5 à 10) pour l'empilement de couches 14, 16 et environ 3 à 20 micromètres pour l'épaisseur de silicium subsistante, incluant les zones photosensibles 12. L'épaisseur subsistante est la couche 30 de la figure 3 contenant les zones photosensibles 12 de la figure 1.

L'opération d'amincissement peut se faire par usinage mécanique (rodage) terminé par un usinage chimique, ou par usinage mécano-chimique, ou par usinage chimique uniquement, ou encore par un procédé de séparation particulier nécessitant au préalable une implantation d'une impureté de fragilisation dans le plan qui délimitera la couche de silicium amincie.

Dans le cas de cette séparation par implantation d'impuretés, il faut effectuer l'implantation avant le report de la tranche de silicium sur la tranche de support. En effet, l'implantation se fait par la face avant de la tranche de silicium, sur toute la surface de celle-ci et à une profondeur qui définira le plan de découpe. L'implantation préalable est de préférence une implantation d'hydrogène. Elle peut être effectuée à divers stades de la fabrication de la tranche, mais la séparation de l'épaisseur de la tranche selon le plan de découpe implanté ne se fait que lorsque la tranche de silicium a été rapportée sur la tranche de support.

La surface supérieure de la couche de silicium amincie 30 peut être traitée (rodage fin, nettoyage chimique, polissage mécano-chimique, etc.) pour éliminer les défauts de surface, aboutissant à une tranche de multiples capteurs dont la structure générale est celle de la figure 3.

Une mosaïque de filtres colorés 18 est alors déposée sur la surface de la couche 30 (figure 4). Si on le souhaite, on peut déposer une ou plusieurs couches supplémentaires avant dépôt des filtres colorés, et notamment des couches de passivation, des couches anti-reflet et d'autres couches, par exemple des couches nécessaires à l'activation électrique des couches de silicium dopées (couches de polarisation électrique).

Si nécessaire une couche de planarisation 24 est déposée sur la mosaïque de filtres. Elle doit être transparente si elle recouvre les filtres. Le substrat provisoire 20 est alors reporté, par sa face avant portant les filtres colorés, sur un substrat transparent définitif 40 (verre ou matière plastique), en forme de tranche de diamètre identique à celui du substrat provisoire et de la tranche de silicium initiale. L'épaisseur du substrat définitif est de quelques centaines de micromètres au moins, pour pouvoir assurer la rigidité de la structure pendant la fabrication. (Figure 5).

Le report du substrat provisoire sur le substrat définitif s'effectue par collage (colle transparente) ou par adhérence moléculaire.

On élimine la majeure partie ou même la totalité du substrat provisoire 20 par des moyens mécaniques et/ou chimiques, ou par fragilisation par implantation d'hydrogène par exemple comme déjà expliqué. Dans ce dernier cas, utilisable pour enlever partiellement le substrat 20, l'implantation d'hydrogène dans la tranche de support 20 doit avoir été faite préalablement au premier report de la tranche de silicium sur la tranche 20 ; cela suppose qu'entre le report sur la tranche 20 et le report sur le substrat 40 il n'y a pas d'opération à des températures susceptibles de provoquer la rupture au niveau du plan d'implantation d'hydrogène.

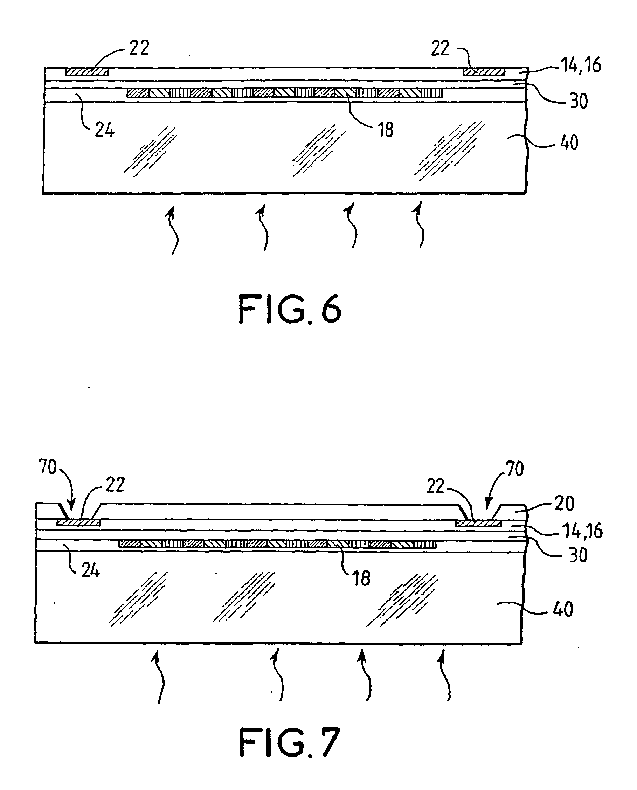

Dans le cas qui est représenté à la figure 6, on élimine totalement le substrat 20, jusqu'à faire affleurer les plots de connexion 22 à la surface de la structure.

Dans le cas de la figure 7, l'élimination du substrat 20 n'est que partielle. Il subsiste une petite épaisseur (quelques micromètres au plus si possible) dans laquelle on formera, par attaque chimique ou autrement, des ouvertures 70 pour dégager des zones d'accès aux plots de connexion 22.

Les plots de connexion dans le cas de la figure 7 peuvent servir pour une connexion de type "wire-bonding" (soudure de fils sur les plots) avec une carte de circuit imprimé. Etant donné que la lumière doit pénétrer du côté du substrat définitif transparent 40, il faut alors que la carte de circuit imprimé soit ouverte en regard de la zone active photosensible du capteur.

Dans le cas de la figure 6, les plots de connexion 22 affleurent au niveau de la surface supérieure du capteur d'image. Ils peuvent être utilisés soit pour une connexion de type "wire-bonding" soit pour une connexion de type "flip-chip" (puce retournée avec les plots de connexion contre des plots correspondants d'une carte de circuit imprimé). Dans ce dernier cas, l'éclairement du capteur se fait par le dessus de la carte de circuit imprimé.

Si on désirait malgré tout utiliser un montage de type flip-chip pour le capteur représenté figure 7, dans laquelle les plots de connexion 22 sont renfoncés dans les ouvertures 70, on procéderait de la manière suivante : on déposerait et on graverait une métallisation supplémentaire reposant à la fois sur la surface extérieure de la structure (c'est-à-dire la surface supérieure du reliquat de substrat 20 dans lequel ont été formées ces ouvertures 70) et dans le fond des ouvertures 70. Les plots de connexion extérieure de la structure seraient alors formés en dehors des ouvertures 70.

Dans ces différents modes de réalisation, la structure formée sur le substrat 40 peut être testée sur tranche par l'intermédiaire des plots de connexion. Le test peut être fait en présence de lumière, de motifs d'image, etc.

La structure n'est découpée en capteurs individuels en vue d'une encapsulation qu'à la fin de ce processus de fabrication.

Le substrat définitif, appliqué étroitement contre la couche mince de silicium portant les filtres colorés, protège à la fois les filtres et le silicium.

## Revendications

1. Procédé de fabrication d'un capteur d'image, comprenant :
- la formation, sur la face avant d'une tranche de matériau semiconducteur (10), d'une série de zones actives (ZA) comportant des circuits de détection d'image et correspondant chacune à un capteur d'image respectif, chaque zone active étant entourée de plots d'entrée/sortie (22),
- le report de la tranche par sa face avant contre la face avant d'un substrat de support provisoire (20),
- l'élimination de la majeure partie de l'épaisseur de la tranche de matériau semiconducteur, laissant subsister sur le substrat une fine couche semiconductrice (30) comprenant les circuits de détection d'image,
ce procédé étant **caractérisé en ce que** :
- d'une part on dépose et on grave ultérieurement des couches de filtres de couleur (18) sur la tranche semiconductrice ainsi amincie,
- d'autre part, postérieurement à la gravure des filtres de couleur, on reporte le substrat provisoire (20) sur un substrat définitif (40), transparent, appliqué du côté du substrat provisoire qui porte les filtres de couleur,
- puis, on enlève au moins la majeure partie du substrat provisoire (20), pour permettre un accès facile aux plots d'entrée/sortie (22),
- et enfin, on découpe le substrat en capteurs individuels.

2. Procédé selon la revendication 1, **caractérisé en ce que** le substrat provisoire est totalement enlevé, mettant à nu les plots d'entrée/sortie (22).

3. Procédé selon la revendication 1, **caractérisé en ce que** le substrat provisoire est enlevé partiellement, en laissant une couche fine qui protège la tranche semiconductrice, et des ouvertures (70) sont formées dans cette fine couche pour accéder aux plots d'entrée/sortie (22).

4. Procédé selon l'une des revendications 1 à 3, **caractérisé en ce que** la couche semiconductrice (30) après amincissement a une épaisseur de 3 à 20 micromètres environ.

5. Procédé selon l'une des revendications 1 à 4, **caractérisé en ce qu'**une couche de planarisation est déposée sur la tranche semiconductrice (10) avant report sur le substrat provisoire.

6. Procédé selon l'une des revendications 1 à 5, **caractérisé en ce qu'**une couche de planarisation transparente (24) est déposée sur la couche semiconductrice amincie (30) avant report du substrat intermédiaire sur le substrat définitif.

7. Capteur d'image comportant un substrat transparent (40) à la partie supérieure duquel sont superposés dans l'ordre une mosaïque de filtres colorés (18), une couche semiconductrice monocristalline très mince (30) dans laquelle est formé un réseau matriciel de zones photosensibles, et un empilement de couches conductrices (14) et isolantes (16) définissant des circuits de détection d'image permettant de recueillir des charges électriques générées par l'illumination des zones photosensibles à travers le substrat transparent, de manière que la lumière passe dans l'ordre à travers le substrat transparent, puis les filtres de couleur, puis les zones semiconductrices photosensibles, avant d'atteindre l'empilement de couches isolantes et conductrices, sans rencontrer un réseau de couches conductrices avant d'atteindre le réseau de zones photosensibles.

8. Capteur d'image selon la revendication 7, **caractérisé en ce que** le substrat transparent (40) est en verre, en matière plastique, en céramique, ou en matériau cristallin

## Claims

1. Method for fabricating an image sensor, comprising:
- the formation of a series of active zones (ZA) on the front face of a semiconductor material wafer (10), which comprise image detection circuits and each correspond to a respective image sensor, each active zone being surrounded by input/output (22) contacts,
- application of the wafer with its front face against the front face of a temporary support substrate (20),
- removal of the majority of the thickness of the semiconductor material wafer, leaving a thin semiconductor layer (30) comprising the image detection circuits remaining on the substrate,
this method being **characterized in that**
- on the one hand colour filter layers (18) are subsequently deposited and etched on the semiconductor wafer thus thinned,
- on the other hand, after the colour filters have been etched, the temporary substrate (20) is applied onto a transparent permanent substrate (40), which is placed on the temporary substrate's side carrying the colour filters,
- then at least the majority of the temporary substrate (20) is removed in order to allow easy access to the input/output contacts (22),
- and finally the substrate is divided into individual sensors.

2. Method according to Claim 1, **characterized in that** the temporary substrate is entirely removed, thus exposing the input/output contacts (22).

3. Method according to Claim 1, **characterized in that** the temporary substrate is partially removed, leaving a thin layer which protects the semiconductor wafer, and openings (70) are formed in this thin layer in order to access the input/output contacts (22).

4. Method according to one of Claims 1 to 3, **characterized in that** the semiconductor layer (30) has a thickness of about 3 to 20 micrometres after thinning.

5. Method according to one of Claims 1 to 4, **characterized in that** a planarizing layer is deposited on the semiconductor wafer (10) before it is applied onto the temporary substrate.

6. Method according to one of Claims 1 to 5, **characterized in that** a transparent planarizing layer (24) is deposited on the thinned semiconductor layer (30) before the temporary substrate is applied onto the permanent substrate.

7. Image sensor comprising a transparent substrate (40) on the upper part of which the following are successively arranged above one another: a mosaic of coloured filters (18), a very thin monocrystalline semiconductor layer (30) in which a matricial network of photosensitive zones is formed, and a stack of conductive layers (14) and insulating layers (16) defining image detection circuits making it possible to collect electrical charges generated by illuminating the photosensitive zones through the transparent substrate, so that the light passes successively through the transparent substrate, then the colour filters, then the photosensitive semiconductor zones before reaching the stack of insulating and conductive layers, without encountering a network of conductive layers before it reaches the network of photosensitive zones.

8. Image sensor according to Claim 7, **characterized in that** the transparent substrate (40) is made of glass, plastic, ceramic or crystalline material.

## Patentansprüche

1. Verfahren zum Herstellen eines Bildsensors mit Folgendem:
- auf der Vorderseite eines Wafers aus Halbleitermaterial (10) Bilden einer Reihe aktiver Zonen (ZA), die Bilderfassungsschaltungen aufweisen und jeweils einem jeweiligen Bildsensor entsprechen, wobei jede aktive Zone von Eingangs-/Ausgangskontakten (22) umgeben ist,
- Übertrag des Wafers über seine Vorderseite gegen die Vorderseite eines vorläufigen Trägersubstrats (20),
- Eliminieren des größten Teils der Stärke des Halbleiter-Wafers, wobei auf dem Substrat nur eine dünne Halbleiterschicht (30), die die Bilderfassungsschaltungen enthält, verbleibt, wobei das Verfahren **dadurch gekennzeichnet ist, dass**
- man einerseits später Farbfilterschichten (18) auf den so verdünnten Halbleiter-Wafer aufbringt oder graviert,
- man andererseits nach dem Gravieren der Farbfilter das vorläufige Substrat (20) auf ein endgültiges durchsichtiges Substrat (40) überträgt, das auf der Seite des vorläufigen Substrats, das die Farbfilter trägt, aufgebracht wird,
- man dann mindestens den größten Teil des vorläufigen Substrats (20) entfernt, um einen leichten Zugang zu den Eingangs-/Ausgangskontakten (22) zu erlauben,
- und man schließlich das Substrat in einzelne Sensoren schneidet.

2. Verfahren nach Anspruch 1, **dadurch gekennzeichnet, dass** das vorläufige Substrat komplett entfernt wird, was die Eingangs-/Ausgangskontakte (22) bloß legt.

3. Verfahren nach Anspruch 1, **dadurch gekennzeichnet, dass** das vorläufige Substrat teilweise entfernt wird, wobei eine dünne Schicht belassen wird, die den Halbleiter-Wafer schützt, und dass Öffnungen (70) in dieser dünnen Schicht gebildet werden, um auf die Eingangs-/Ausgangskontakte (22) zuzugreifen.

4. Verfahren nach einem der Ansprüche 1 bis 3, **dadurch gekennzeichnet, dass** die Halbleiterschicht (30) nach dem Verdünnen eine Stärke von etwa 3 bis 20 Mikrometer aufweist.

5. Verfahren nach einem der Ansprüche 1 bis 4, **dadurch gekennzeichnet, dass** eine Planarisierungsschicht auf dem Halbleiter-Wafer (10) vor dem Übertrag auf das vorläufige Substrat aufgebracht wird.

6. Verfahren nach einem der Ansprüche 1 bis 5, **dadurch gekennzeichnet, dass** eine durchsichtige Planarisierungsschicht (24) auf der verdünnten Halbleiterschicht (30) vor dem Übertrag des Zwischensubstrats auf das endgültige Substrat aufgebracht wird.

7. Bildsensor mit einem durchsichtigen Substrat (40), auf dessen oberem Teil nacheinander ein Mosaik aus Farbfiltern (18), eine sehr dünne monokristalline Halbleiterschicht (30), in der ein Matrixnetz mit photosensiblen Zonen ausgebildet ist, und eine Stapelung leitender (14) und isolierender (16) Schichten, die Bilderfassungsschaltungen definieren, die es erlauben, elektrische Ladungen zu sammeln, die durch das Beleuchten der photosensiblen Zonen durch das durchsichtige Substrat erzeugt werden, aufgebracht werden, so dass das Licht nacheinander durch das durchsichtige Substrat, dann durch die Farbfilter, dann durch die photosensiblen Halbleiterzonen geht, bevor es die Stapelung isolierender und leitender Schichten erreicht, ohne auf ein Netz leitender Schichten zu treffen, bevor es das Netz photosensibler Zonen erreicht.

8. Bildsensor nach Anspruch 7, **dadurch gekennzeichnet, dass** das durchsichtige Substrat (40) aus Glas, Kunststoff, Keramik oder kristallinem Material besteht.
